# EUROPÄISCHE PATENTSCHRIFT

(11) **EP 3 234 968 B1**
(45) Veröffentlichungstag und Bekanntmachung des Hinweises auf die Patenterteilung: **10.04.2019**
(21) Anmeldenummer: 15816399.8
(22) Anmeldetag: 11.12.2015
(51) Int. Cl.: H01F 41/04, B81C 1/00, H01F 41/16, H01F 41/30

(54) **VERFAHREN ZUM HERSTELLEN EINER VORRICHTUNG MIT EINER DREIDIMENSIONALEN MAGNETISCHEN STRUKTUR**
METHOD FOR PRODUCING A DEVICE HAVING A THREE-DIMENSIONAL MAGNETIC STRUCTURE
PROCÉDÉ DE FABRICATION D'UN DISPOSITIF POURVU D'UNE STRUCTURE MAGNÉTIQUE TRIDIMENSIONNELLE

(30) Priorität: 16.12.2014 DE 102014226138
(43) Veröffentlichungstag der Anmeldung: 25.10.2017
(73) Patentinhaber: Fraunhofer-Gesellschaft zur Förderung der angewandten Forschung e.V., 80686 München (DE)
(72) Erfinder: LISEC, Thomas, 25524 Itzehoe (DE); QUENZER, Hans-Joachim, 25524 Itzehoe (DE); REIMER, Tim, 24143 Kiel (DE)
(74) Vertreter: Zimmermann, Tankred Klaus
(86) Internationale Anmeldenummer: PCT/EP2015/079362
(87) Internationale Veröffentlichungsnummer: WO 2016/096636

(56) Entgegenhaltungen:
- DE-A1-102011 010 899
- US-A1- 2013 169 381
- OLOLADE D ONIKU ET AL: "Paper;Permanent magnet microstructures using dry-pressed magnetic powders;Permanent magnet microstructures using dry-pressed magnetic powders", JOURNAL OF MICROMECHANICS & MICROENGINEERING, INSTITUTE OF PHYSICS PUBLISHING, BRISTOL, GB, Bd. 23, Nr. 7, 12. Juni 2013 (2013-06-12), Seite 75027, XP020247167, ISSN: 0960-1317, DOI: 10.1088/0960-1317/23/7/075027
- YANG TZU-SHUN ET AL: "Fabrication and characterization of parylene-bonded Nd-Fe-B powder micromagnets", JOURNAL OF APPLIED PHYSICS, AMERICAN INSTITUTE OF PHYSICS, US, Bd. 109, Nr. 7, 12. April 2011 (2011-04-12), Seiten 7A753-7A753, XP012148149, ISSN: 0021-8979, DOI: 10.1063/1.3566001
- YANG C ET AL: "On-chip RF inductors with magnetic nano particles medium", 2011 16TH INTERNATIONAL SOLID-STATE SENSORS, ACTUATORS AND MICROSYSTEMS CONFERENCE (TRANSDUCERS 2011) : BEIJING, CHINA, 5 - 9 JUNE 2011, IEEE, PISCATAWAY, NJ, 5. Juni 2011 (2011-06-05), Seiten 2801-2804, XP031911006, DOI: 10.1109/TRANSDUCERS.2011.5969699 ISBN: 978-1-4577-0157-3
- JING ZHAN ET AL: "Stacked-Spiral RF Inductor With Vertical Nano-Powder Magnetic Core in CMOS", IEEE MICROWAVE AND WIRELESS COMPONENTS LETTERS, IEEE SERVICE CENTER, NEW YORK, NY, US, Bd. 22, Nr. 1, Januar 2012 (2012-01), Seiten 29-31, XP011391839, ISSN: 1531-1309, DOI: 10.1109/LMWC.2011.2176474
- SAWANT SHASHANK G ET AL: "Fabrication, Characterization, and Modeling of Fully-Batch-Fabricated Piston-Type Electrodynamic Microactuators", JOURNAL OF MICROELECTROMECHANICAL SYSTEMS, IEEE SERVICE CENTER, US, Bd. 23, Nr. 1, Februar 2014 (2014-02), Seiten 220-229, XP011538808, ISSN: 1057-7157, DOI: 10.1109/JMEMS.2013.2271293 [gefunden am 2014-01-30]

## Beschreibung

Ausführungsbeispiele der vorliegenden Erfindung beziehen sich auf ein Verfahren zum Herstellen einer Vorrichtung mit einer dreidimensionalen magnetischen Struktur. Weitere Ausführungsbeispiele beziehen sich auf eine Vorrichtung mit einer dreidimensionalen magnetischen Struktur. Manche Ausführungsbeispiele beziehen sich auf eine Integration magnetischer Materialien auf Substrate.

Mittels Techniken der IC-Technologie (IC = Integrated Circuit, dt.: integrierter Schaltkreis) können auf Halbleitersubstraten sehr kleine Spulen hergestellt werden. Kleine Spulen ohne Spulenkerne aus magnetischen Materialien weisen jedoch generell eine geringe Induktivität auf. Die Integration von Spulenkernen aus geeigneten magnetischen Materialien ist jedoch alles andere als einfach, da vergleichsweise große Schichtdicken benötigt werden. Daher werden für elektronische Module mit größeren Induktivitäten nach wie vor SMD-Bauteile (SMD = Surface-Mounted Device, dt.: oberflächenmontiertes Bauelement) benötigt, deren Spulenkörper entweder ganz klassisch durch Aufwickeln eines Drahtes um einen magnetischen Kern oder mittels keramischer Technologie in LTCC Keramiken (LTCC = Low Temperature Cofired Ceramics, dt.: Niedertemperatur-Einbrand-Keramiken) hergestellt werden. Die Baugröße von SMD-Bauteilen liegt allerdings typischerweise im Millimeterbereich. Zudem weisen SMD-Bauteile erhebliche Streuungen in der Größe der Induktivitäten auf. Eine erhebliche Verbesserung der Leistungsfähigkeit planarer, integrierter Spulen auf planaren Substraten, wie z.B. Silizium, könnte durch die Integration magnetischer Kerne direkt in das Substrat erzielt werden.

Aber nicht nur für Induktoren, auch für mikromechanische Bauelemente und Sensoren wären auf dem Substrat integrierbare magnetische Strukturen von großem Interesse. Magnetische Aktuatoren haben ihre Vorteile im Vergleich zu anderen Antriebsprinzipien. Bisher konnten hohe Kräfte jedoch nur mit auf Chipebene montierten Permanentmagneten erzielt werden. Wie im Falle der Induktoren ist das weder mit der Baugröße noch mit den Kosten miniaturisierter Systeme zu vereinbaren. Zudem verwehrt die Montage solcher Magnete deren Nutzung in hermetisch dichten Gehäusen die mittels Waferbonden hergestellt werden, da die beim Bonden benötigten Temperaturen nicht kompatibel mit Klebeverbindungen sind.

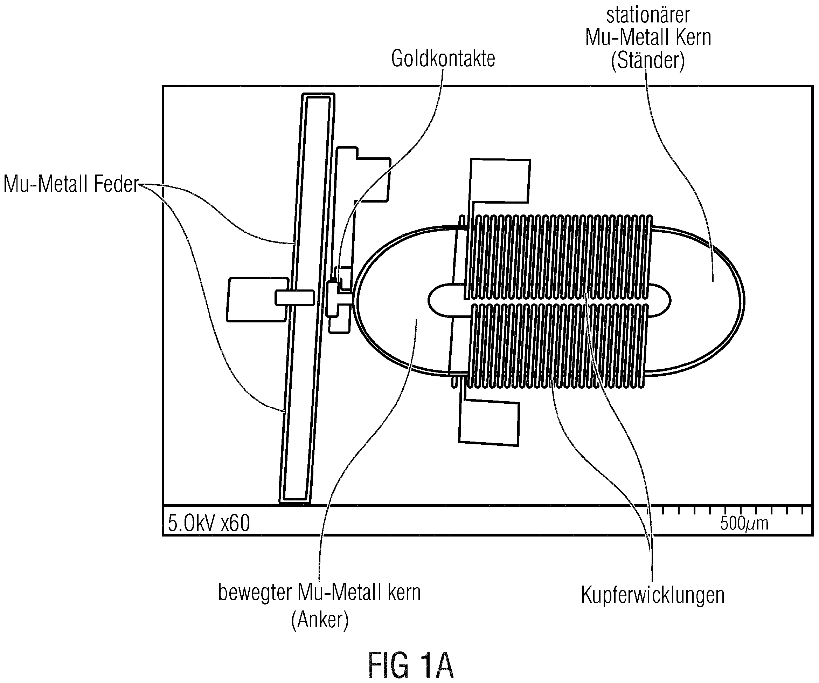

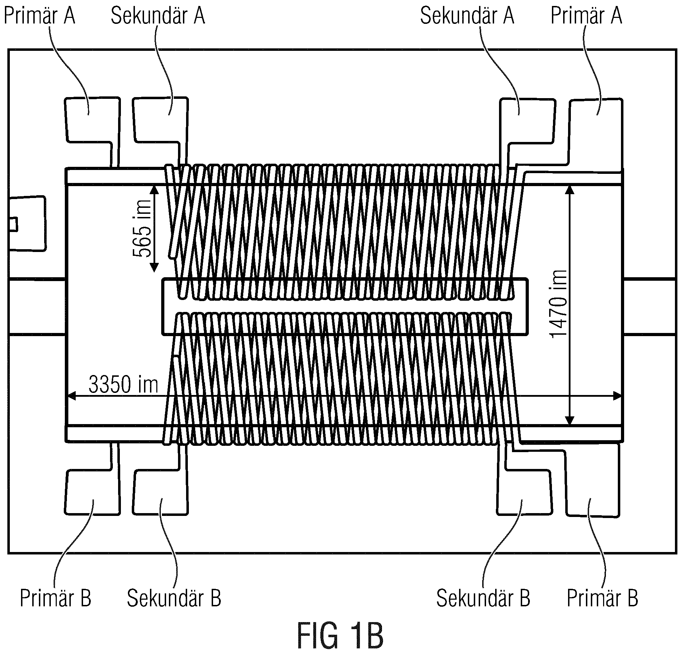

Metallische ferromagnetische Schichten können im Gegensatz zu leistungsfähigen hartmagentischen Schichten gut elektrochemisch abgeschieden werden. Fig. 1a zeigt einen magnetisch betätigten, ohmschen MEMS-Schalter (MEMS = Micro-Electro-Mechanical-Systems, dt.: Mikrosystem) basierend auf einer Zylinderspule aus Kupfer mit 10 µm dicken Permalloy-Kern [M. Glickman et. al., "High-performance lateral-actuating magnetic MEMS switch", J. Micromech. Sys., Vol. 20, No. 2, 2011]. In Fig. 1b ist ein ähnlich aufgebauter Transformator mit galvanisch abgeschiedenem NiFe-Kern abgebildet [R. J. Rassel et. al., "Fabrication and characterization of a solenoid-type microtransformer", Transact. on Magnetics, Vol. 39, No. 1, 2003]. Generell zeichnen sich Fe-, Ni- oder Co-basierte Legierungen durch hohe Permeabilität und Sättigungsinduktion aus. Mit steigender Frequenz kommt es jedoch zu erheblichen Verlusten aufgrund von Wirbelströmen und ferromagnetischer Resonanz im Metall. Der Arbeitsbereich des Transformators in [R. J. Rassel et. al., "Fabrication and characterization of a solenoid-type microtransformer", Transact. on Magnetics, Vol. 39, No. 1, 2003] ist z.B. auf Frequenzen im geringen kHz-Bereich beschränkt. In [D. W. Lee et. al., "Design and fabrication of integrated solenoid inductors with magnetic cores", Proc. ECTC 2008] wird eine Zylinderspule mit ca. 2 µm dickem, gesputterten CoTaZr-Kern und guter Leistungsfähigkeit bei einigen 10 MHz vorgestellt.

Für höherfrequente Anwendungen sind Ferrite aufgrund des hohen elektrischen Widerstandes wesentlich besser geeignet. Die Permeabilität dieser Materialien kann recht hoch sein, die Sättigungsinduktion ist zumeist vergleichsweise gering. Die klassischen Herstellungsverfahren von Ferrit-Magneten sind aufgrund hoher Temperaturen nicht mit der IC-Technologie (IC = Integrated Circuit, dt.: integrierter Schaltkreis) kompatibel. Sputtern von Ferriten ist problematisch, da es sich um komplexe Verbindungen aus mehreren Elementen handelt. Zudem erfordern gesputterte Schichten unter Umständen eine thermische Nachbehandlung zur Einstellung der Kristallstruktur. Das Ätzen von Ferrit-Schichten ist ebenfalls schwierig. In [Y. Mano et. al., "Planar inductors with ferrite layers for DC-DC converters, Proc. Transducers 2005, Seoul, Korea] wird eine planare Spule, eingebettet in galvanisch abgeschiedenes Ni-Fe-Ferrit, beschrieben. Da galvanische Abscheidungen unter Verwendung von Fotomasken erfolgen, ist ein nachfolgende Strukturierung der Schichten nicht notwendig.

Durch das Stapeln (engl. stacking) mehrerer dünner, weichmagnetischer Schichten mit Dielektrika kann das Wirbelstromproblem reduziert werden. In [D. S. Gardner et. al.,"Review of on-chip inductor structures with magnetic films", Transact. on Magnetics, Vol. 45, No. 10, 2009] werden planare Spulen mit ca. 2 µm dicken CoTaZr- und NiFe-Kernen untersucht, die aus Stapeln (engl. stacks) des gesputterten magnetischen Materials und dünnen Kobaltoxidschichten bestehen. In [J. Zhao et. al., "Fabricate high performance RF-MEMS inductor with a smart nano magnetic granular film according to function purpose, Proc. Conf. on Nanomaterials 2013, Bejing, China] werden Induktoren mit einer gesputterten Schicht aus in SiO₂ eingebetteten Permalloy-Partikeln unter- bzw. oberhalb einer planaren Spule beschrieben. Dadurch werden Wirbelströme ebenfalls effektiv unterdrückt.

Die Einbettung magnetischer Partikel in Polymere ist eine weitere Möglichkeit. In [S. Engelkraut et. al., "Polymer bonded soft magnetic particles for planar inductive devices", Proc. CIPS 2008, Nürnberg, Germany] werden zur Herstellung von Transformatoren polymergebundene magnetische Partikel durch Spritzguß auf Leiterplatten mit planaren Spulen aufgebracht. In [P. Markondeya et. al., "Novel nanomagnetic materials for high-frequency RF applications", Proc. ECTC 2011] wird die Synthese von Kobalt-Nanopartikeln mit SiO₂-Ummantelung beschrieben. Eingebettet in eine Polymermatrix, z.B. BCB (BCB = Benzocyclobuten), werden die Nanopartikel durch Siebdruck auf die Substratoberfläche aufgebracht. Spritzguss- und Siebdruckverfahren sind zwar bezüglich der minimalen Strukturbreiten begrenzt, es entfällt jedoch das Strukturieren der PolymerPartikel-Schichten, für das es keine geeigneten Verfahren gibt. Eine interessante Alternative ist das Drucken magnetischer Tinten, da auf diese Weise vergleichsweise feine Strukturen erzeugt werden können. [S. Lyshevski, K. Martirosyan, "Ferrite nanoparticles for MEMS technology sensors and actuators", Proc. Conf. on Nanotechnology, Portland, Oregon, USA, 2011] beschreibt die Synthese verschiedener Ferritpartikel sowie deren Aufbringen auf ein Substrat durch Tintenstrahldrucken. Damit die Partikel nach dem Trocknen auf dem Substrat verbleiben, ist der Tinte ein Polymer beigefügt, in diesem Falle PMMA (Polymethylmethacrylat).

Die allermeisten magnetisch betriebenen MEMS Bauelemente vermeiden die Integration magnetischer Materialien und nutzen stattdessen Aktuatoren auf Basis der Lorentzkraft. In diesen Antriebsstrukturen wird die Kraft genutzt, die stromdurchflossene Leiterbahnen in einem äußeren statischen Magnetfeld erfahren. Der Vorteil dieses Antriebsprinzips ist letztlich, dass die Integration magnetischer Materialien in ein MEMS Bauelement selbst vermieden werden kann, allerdings sind die erreichbaren Kräfte jedoch sehr begrenzt.

Integrierte magnetische Aktuatoren für den Betrieb mikromechanischer Bauelemente wurden bisher nur auf der Basis galvanisch abgeschiedener weichmagnetischer Schichten beschrieben, wie z. B. der Schalter in Fig. 1a [M. Glickman et. al. "High-performance lateral-actuating magnetic MEMS switch", J. Micromech. Sys., Vol. 20, No. 2, 2011]. Genaugenommen ist das jedoch ein Spezialfall, da nur eine schmale Lücke (engl. gap) in einem magnetischen Kern durch Anlegen einer äußeren Spannung geschlossen wird. Baugröße und generierte Kraft sind vergleichbar zu lateralen elektrostatisch betätigten Schaltern, wie z. B. in [S. Leidich et. al., " RF-MEMS switch with ohmic contact and lateral actuation", Proc. Microsystemtechnik Kongress 2011, Darmstadt, Germany] beschrieben wird.

Wesentliche Vorteile integrierter magnetischer Antriebe sind große Hübe und große Kräfte. Darüber hinaus erlaubt dieses Antriebsprinzip die Nutzung externer Spulen, wodurch in diesem hybriden Ansatz große Kräfte und Hübe erreichbar werden. Da die erzielbaren magnetischen Kräfte von den Dimensionen der magnetischen Struktur abhängen, sind große Dicken vorteilhaft. Da magnetische Aktuatoren im niederfrequenten Bereich bzw. mit Gleichstrom betätigt werden, spielen die für Induktoren wichtigen Verlustmechanismen keine Rolle.

Verfahren wie Sputtern oder PLD (PLD = Pulsed Laser Deposition, dt.: Laserstrahlverdampfen) sind allerdings nur für Schichten von wenigen µm Dicke geeignet. Mittels galvanischer Abscheidung lassen sich dickere Schichten erzeugen [X.-M. Sun et. al., "Electrodeposition and characterization of CoNiMnP-based permanent magnetic film for MEMS applications", Proc. NEMS 2011, Kaohsiung, Taiwan]. Aufgrund von Stresseffekten können jedoch schon wenige 10 µm dicke galvanische Metallschichten problematisch werden. Zudem werden mit hartmagnetischen Materialien größere Kräfte erzielt als mit weichmagnetischen. Deren Abscheidung ist jedoch deutlich schwieriger, insbesondere wenn Hochleistungswerkstoffe wie etwa SmCo oder NdFeB für Hochfeldmagnete eingesetzt werden sollen.

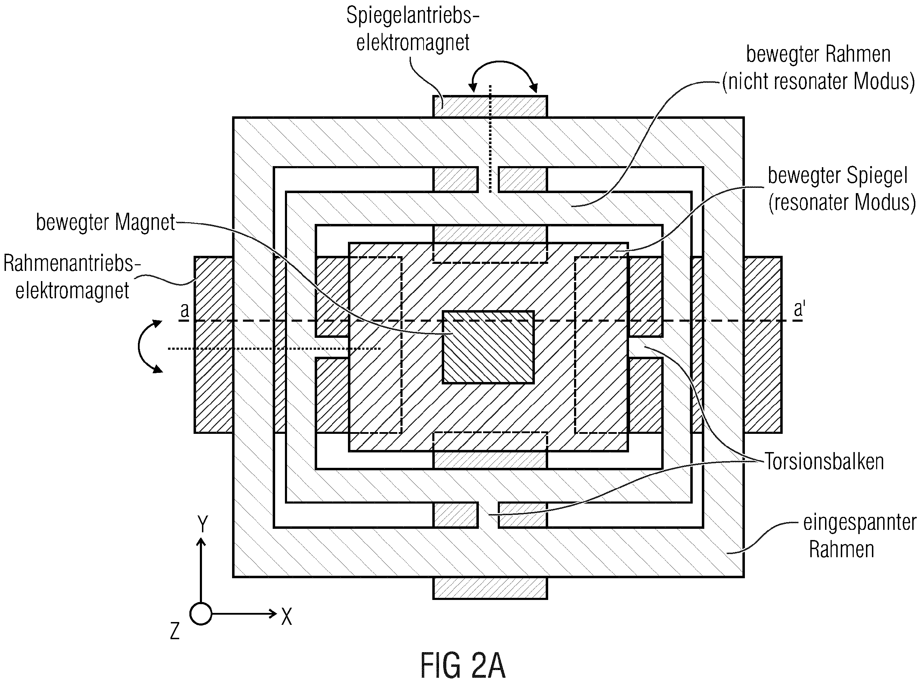

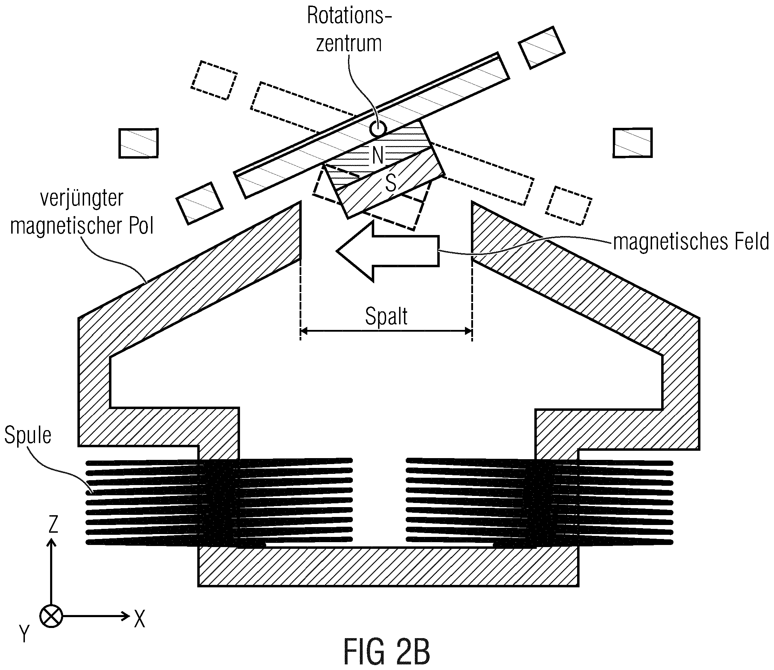

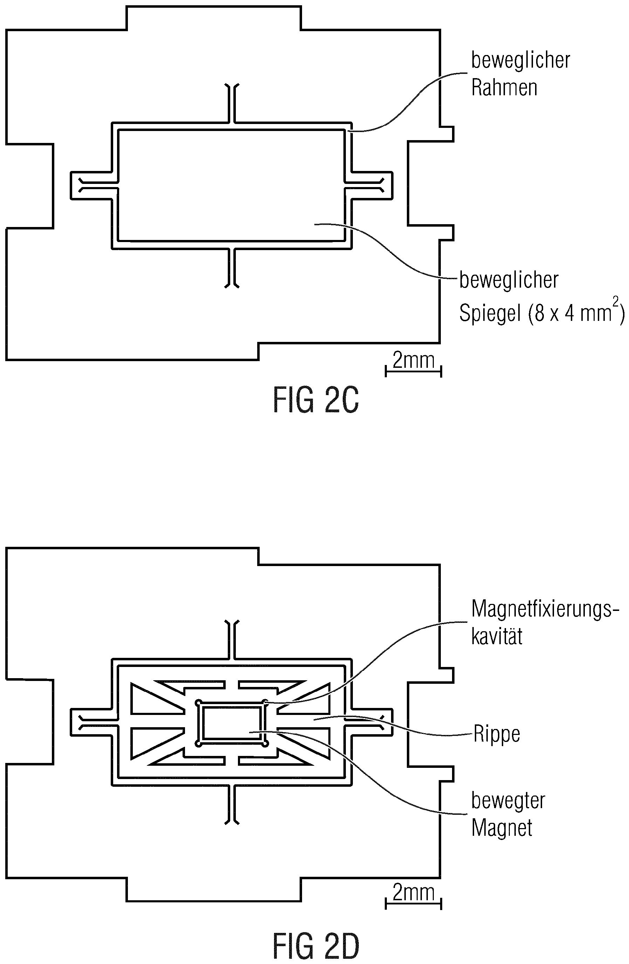

Für viele magnetische Aktuatoren werden daher nach wie vor Miniatur-Permanentmagnete auf Chipebene montiert. Ein aktuelles Beispiel dafür ist der 2D-Scanner in [I. Aoyagi et. al., "A raster-output 2D MEMS scanner with an 8x4 mm mirror for an automotive time-of-flight image sensor" Proc. Transducers 2013, Barcelona, Spain], siehe Fig. 2a-d. Nur die bewegliche Struktur bzw. dessen Rahmen bestehen aus Silizium. In einem weiteren Beispiel [Yu et. al., "Silicon-embedded toroidal inductors with magnetic cores: Design methodology and experimental validation", Proc. APEC 2014, Fort Worth, TX, USA] wird auf einem Siliziumsubstat eine Spule mit magnetischem Kern durch Einbetten eines ringförmiger Permanentmagneten in eine geätzte Kavität hergestellt. In die Kavität wurden vorher metallische Leitbahnen abgeschieden. Durch eine zweite Leitbahnebene nach dem Einbetten des Magneten werden diese zu einer Spule verbunden.

In der Veröffentlichung [OLOLADE D ONIKU ET AL: "Paper; Permanent magnet microstructures using dry-pressed magnetic powders; Permanent magnet microstructures using dry-pressed magnetic powders", JOURNAL OF MICROMECHANICS & MICROENGINEERING, INSTITUTE OF PHYSICS PUBLISHING, BRISTOL, GB, Bd. 23, Nr. 7, 12. Juni 2013 (2013-06-12), Seite 75027, XP020247167, ISSN: 0960-1317, DOI: 10.1088/0960-1317/23/7/075027] wird ein Verfahren zur Herstellung von Permanentmagnetmikrosturen unter Verwendung von trockengepressten Magnetpulvern beschrieben.

In der Veröffentlichung [YANG TZU-SHUN ET AL: "Fabrication and characterization of parylene-bonded Nd-Fe-B powder micromagnets", JOURNAL OF APPLIED PHYSICS, AMERICAN INSTITUTE OF PHYSICS, US, Bd. 109, Nr. 7, 12. April 2011 (2011-04-12), Seiten 7A753-1 - 7A753-3, XP012148149, ISSN: 0021-8979, DOI: 10.1063/1.3566001] wird die Herstellung von Nd-Fe-B Pulver basierten Mikromagneten beschrieben.

In der Veröffentlichung [YANG C ET AL: "On-chip RF inductors with magnetic nano particles medium", 2011 16TH INTERNATIONAL SOLID-STATE SENSORS, ACTUATORS AND MICROSYSTEMS CONFERENCE (TRANSDUCERS 2011) : BEIJING, CHINA, 5 - 9 JUNE 2011, IEEE, PISCATAWAY, NJ, 5. Juni 2011 (2011-06-05), Seiten 2801-2804, XP031911006, DOI: 10.1109/TRANSDUCERS.2011.5969699 ISBN: 978-1-4577-0157-3] werden auf dem Chip ausgeführte, auf magnetischen Nanopartikeln basierende RF Induktoren beschrieben.

In der Veröffentlichung [JING ZHAN ET AL: "Stacked-Spiral RF Inductor With Vertical Nano-Powder Magnetic Core in CMOS", IEEE MICROWAVE AND WIRELESS COMPONENTS LETTERS, IEEE SERVICE CENTER, NEW YORK, NY, US, Bd. 22, Nr. 1, 1. Januar 2012 (2012-01-01), Seiten 29-31, XP011391839, ISSN: 1531-1309, DOI: 10.1109/LMWC.2011.2176474] werden gestapelte RF Induktoren mit vertikalen, auf magnetischem Nanopulver basierenden Kernen beschrieben.

Die US 2013/169381 A1 beschreibt ein Gleichtaktfilter und ein Verfahren zur Herstellung desselben.

In der Veröffentlichung [SAWANT SHASHANK G ET AL: "Fabrication, Characterization, and Modeling of Fully-Batch-Fabricated Piston-Type Electrodynamic Microactuators", JOURNAL OF MICROELECTROMECHANICAL SYSTEMS, IEEE SERVICE CENTER, US, Bd. 23, Nr. 1, 1. Februar 2014 (2014-02-01), Seiten 220-229, XP011538808, ISSN: 1057-7157, DOI: 10.1109/JMEMS.2013.2271293] wird die Herstellung und Charakterisierung von elektrodynamischen Mikroaktuatoren beschrieben.

In der DE 10 2011 010899 A1 wird ein Verfahren zum Erzeugen einer dreidimensionalen Struktur beschrieben. Das Verfahren umfasst Auf- oder Einbringen von Partikeln auf oder in ein Trägerelement, wobei zwischen den Partikeln eine Vielzahl von zumindest teilweise miteinander verbundener Hohlräume gebildet wird und wobei die Partikel an Berührungspunkten miteinander in Kontakt treten, Verbinden der Partikel an den Berührungspunkten durch Beschichten der Anordnung aus Partikeln und Trägerelement, wobei die Hohlräume zumindest teilweise von der beim Beschichten erzeugten Schicht durchdrungen werden.

Der vorliegenden Erfindung liegt somit die Aufgabe zugrunde, ein Konzept zu schaffen, welches eine Integration magnetischer Materialien auf Substraten ermöglicht.

Diese Aufgabe wird durch die unabhängigen Patentansprüche gelöst. Vorteilhafte Weiterbildungen finden sich in den abhängigen Patentansprüchen.

Ausführungsbeispiele der vorliegenden Erfindung schaffen ein Verfahren zum Herstellen einer Vorrichtung mit einer dreidimensionalen magnetischen Struktur gemäß Anspruch 1.

Der vorliegenden Erfindung liegt die Idee zugrunde, eine dreidimensionale magnetische Struktur zur Erzielung von hohen Induktivitäten bei Spulenanwendungen oder hohen magnetischen Antriebskräften bei Aktuatoranwendungen durch Einbringen (oder Aufbringen) von magnetischen Partikeln in (oder auf) ein Tägerelement und anschließendes Beschichten der Anordnung aus magnetischen Partikeln durch Abscheiden einer Schicht herzustellen.

Ausführungsbeispiele der vorliegenden Erfindung werden Bezug nehmend auf die beiliegenden Figuren näher erläutert. Es zeigen:
- Fig. 1a: eine schematische Ansicht eines mikromechanischen ohmschen Schalters basierend auf Zylinderspulen mit galvanisch abgeschiedenem NiFe-Kern;
- Fig. 1b: eine schematische Ansicht eines mikromechanischen Transformators basierend auf Zylinderspulen mit galvanisch abgeschiedenem NiFe-Kern;
- Fig. 2a: eine schematische Draufsicht eines Aufbaus eines 2D-Scanners;
- Fig. 2b: eine schematische Seitenansicht eines Aufbaus eines 2D-Scanners;
- Fig. 2c: ein Foto einer ersten Seite eines Si-Chips mit einem aufmontierten Magneten;
- Fig. 2d: ein Foto einer zweiten Seite des Si-Chips mit dem aufmontierten Magneten;
- Fig. 3: ein Flussdiagramm eines Verfahrens zum Herstellen einer Vorrichtung mit einer dreidimensionalen magnetischen Struktur, gemäß einem Ausführungsbeispiel der vorliegenden Erfindung;
- Fig. 4a: eine schematische Querschnittsansicht einer Leiterschleifenanordnung auf einem Trägerelement, gemäß einem Ausführungsbeispiel der vorliegenden Erfindung;
- Fig. 4b: eine schematische Draufsicht der in Fig. 4a gezeigten Leiterschleifenanordnung auf dem Trägerelement, gemäß einem Ausführungsbeispiel der vorliegenden Erfindung;
- Fig. 5a-d: schematische Querschnitte einer Vorrichtung mit einer dreidimensionalen magnetischen Struktur und einer Leiterschleifenanordnung nach unterschiedlichen Herstellungsschritten; und
- Fig. 6a-e: schematische Querschnitte einer Vorrichtung mit einer dreidimensionalen magnetischen Struktur und einer Leiterschleifenanordnung nach unterschiedlichen Herstellungsschritten.

In der nachfolgenden Beschreibung der Ausführungsbeispiele der Erfindung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

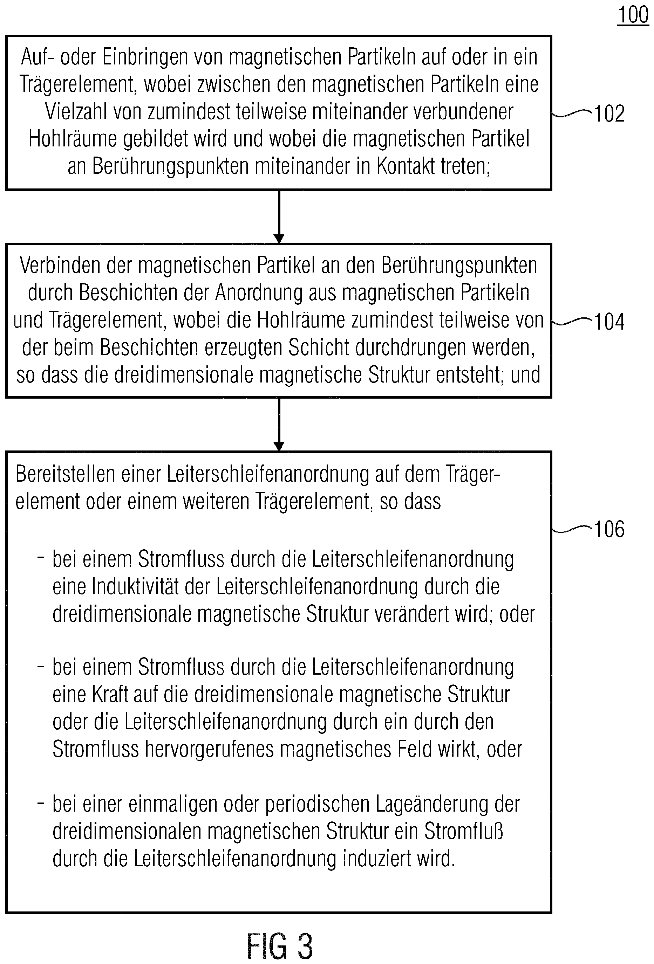

Fig. 3 zeigt ein Flussdiagramm eines Verfahrens 100 zum Herstellen einer Vorrichtung mit einer dreidimensionalen magnetischen Struktur. Das Verfahren 100 umfasst einen Schritt 102 des Auf- oder Einbringens von magnetischen Partikeln auf oder in ein Trägerelement, wobei zwischen den magnetischen Partikeln eine Vielzahl von zumindest teilweise miteinander verbundener Hohlräume gebildet wird und wobei die magnetischen Partikel an Berührungspunkten miteinander in Kontakt treten. Das Verfahren 100 umfasst ferner einen Schritt 104 des Verbindens der magnetischen Partikel an den Berührungspunkten durch Beschichten der Anordnung aus magnetischen Partikeln und Trägerelement, wobei die Hohlräume zumindest teilweise von der beim Beschichten erzeugten Schicht durchdrungen werden, so dass die dreidimensionale magnetische Struktur entsteht. Das Verfahren 100 umfasst ferner einen Schritt 106 des Bereitstellens einer Leiterschleifenanordnung auf dem Trägerelement oder einem weiteren Trägerelement, so dass bei einem Stromfluss durch die Leiterschleifenanordnung eine Induktivität der Leiterschleifenanordnung durch die dreidimensionale magnetische Struktur verändert wird, oder so dass bei einem Stromfluss durch die Leiterschleifenanordnung eine Kraft auf die dreidimensionale magnetische Struktur oder die Leiterschleifenanordnung durch ein durch den Stromfluss hervorgerufenes magnetisches Feld wirkt, oder so dass bei einer Lageänderung (z.B. einer einmaligen oder periodischen Lageänderung) der dreidimensionalen magnetischen Struktur ein Stromfluß durch die Leiterschleifenanordnung induziert wird.

Gemäß Ausführungsbeispielen wird eine dreidimensionale magnetische Struktur zur Erzielung von hohen Induktivitäten bei Spulenanwendungen oder hohen magnetischen Antriebskräften bei Aktuatoranwendungen durch Einbringen (oder Aufbringen) von magnetischen Partikeln in (oder auf) ein Tägerelement und anschließendes Beschichten der Anordnung aus magnetischen Partikeln durch Abscheiden einer Schicht hergestellt.

Um die erzielbaren Induktivitäten bei Spulenanwendungen oder magnetischen Antriebskräfte bei Aktuatoranwendungen weiter zu steigern, kann bei Ausführungsbeispielen die abgeschiedene Schicht, mit der die magnetischen Partikel verbunden werden, ebenfalls magnetisch sein.

Erfindungsgemäß wird das Beschichten der Anordnung aus magnetischen Partikeln und Trägerelement mittels Atomlagenabscheidung durchgeführt.

Ferner kann eine dielektrische Schicht vor oder nach dem Abscheiden der magnetischen Schicht abgeschieden werden. Die Anordnung aus magnetischen Partikeln kann somit durch mehrfache Beschichtung weiter funktionalisiert werden, z. B. kann auf eine erste Beschichtung mit einem dielektrischen Material eine Beschichtung mit einem magnetischen Material folgen, und umgekehrt.

Mit anderen Worten, die magnetischen Partikel können bei Ausführungsbeispielen durch einen ALD-Prozess (ALD = Atomic Layer Deposition, dt.: Atomlagenabscheidung) miteinander verbunden bzw. fixiert werden. Hierbei kann jedes Material auf das Trägerelement (z.B. Substrat) aufgebracht bzw. eingebracht werden, das zum Befestigungsprozess kompatibel ist, d.h. der ALD-Abscheidung. Mit dem vorgenannten Verfahren kann eine hohe Packungsdichte erzielt werden.

Die ALD Schichten können dabei selbst aus magnetischen Materialien bestehen, wie z. B. Fe, Ni oder Co-Oxiden bzw. deren Verbindungen oder Mischungen. Für die Herstellung magnetischer oder hartmagnetischer Strukturen kommen darüber hinaus auch metallische Werkstoffe wie Fe, Ni, und Co sowie deren Legierungen in Frage. Da diese Materialien nicht einfach auf einem direkten Wege mittels ALD abgeschieden werden können, erfolgt zunächst eine Abscheidung der entsprechenden Oxide (Fe, Ni, Co. und deren Mischungen) und anschließend wird das Oxid durch eine chemische Reduktion in die entsprechenden Metalle und - Legierung überführt.

Im Vergleich zu polymergebundenen Systemen für die Herstellung der Permanentmagnete sollten deutlich kleinere magnetische Strukturen mit Abmessungen bis zu wenigen µm reproduzierbar hergestellt werden können.

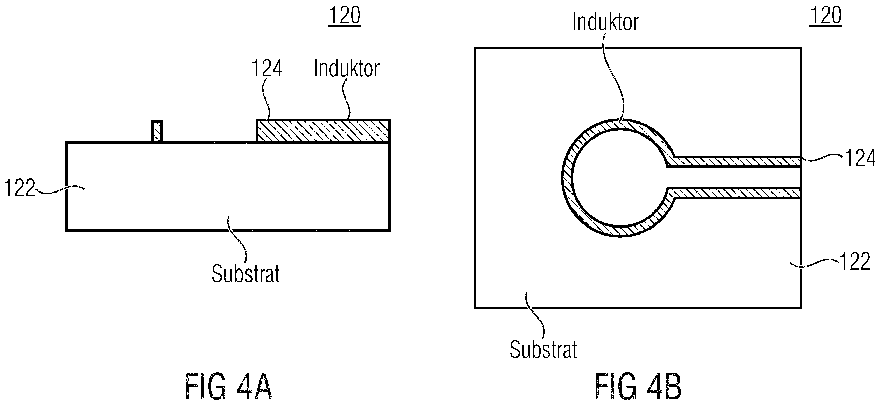

Im Folgenden wird das in Fig. 3 gezeigte Verfahren 100 zum Herstellen einer Vorrichtung mit einer dreidimensionalen magnetischen Struktur anhand der Fig. 4a bis 6e detailliert beschrieben.

Wie bereits erwähnt umfasst das Verfahren 100 zum Herstellen einer Vorrichtung mit einer dreidimensionalen magnetischen Struktur einen Schritt 106 des Bereitstellens einer Leiterschleifenanordnung auf dem Trägerelement oder einem weiteren Trägerelement. Fig. 4a zeigt dabei eine schematische Querschnittsansicht der Vorrichtung 120 nach dem Schritt des Bereitstellens einer Leiterschleifenanordnung 124 auf dem Trägerelement (z.B. Substrat), während Fig. 4b eine schematische Draufsicht desselben zeigt. Natürlich könnte das in Fig. 4a und 4b gezeigte Trägerelement 122 auch das weitere Trägerelement sein. Das Trägerelement 122 (oder weitere Trägerelement) kann beispielsweise Kunststoff, Silizium, Glas oder Keramik aufweisen oder eine Leiterplatte sein. Die Leiterschleifenanordnung 124 kann beispielsweise eine (planere) Spule oder ein (planerer) Induktor sein.

Ferner umfasst das Verfahren einen Schritt 102 des Auf- oder Einbringens von magnetischen Partikeln auf oder in das Trägerelement 122 und einen Schritt des Verbindens der magnetischen Partikel durch Beschichten, so dass die dreidimensionale magnetische Struktur auf oder in dem Trägerelement entsteht.

Bei Spulenanwendungen kann die Leiterschleifenanordnung 124 beispielsweise auf dem Trägerelement 122 bereitgestellt werden, d.h. auf dem gleichen Trägerelement wie die dreidimensionale magnetische Struktur (mit anderen Worten, die Leiterschleifenanordnung und die dreidimensionale magnetische Struktur sind auf dem Trägerelement 122 angeordnet), so dass eine Induktivität der Leiterschleifenanordnung 124 durch die dreidimensionale magnetische Struktur verändert (z.B. erhöht oder erniedrigt) wird. Bei Aktuatoranwendungen kann die Leiterschleifenanordnung 124 beispielsweise auf dem weiteren Trägerelement bereitgestellt werden, so dass bei einem Stromfluss durch die Leiterschleifenanordnung 124 eine Kraft auf die dreidimensionale magnetische Struktur oder die Leiterschleifenanordnung 124 durch ein durch den Stromfluss hervorgerufenes magnetisches Feld wirkt. Für Sensoranwendungen oder Energy Harvester ist auch möglich, daß durch eine einmalige Lageänderung oder periodische Bewegung der dreidimensionalen magnetischen Struktur auf dem Trägerelement 122 in der, auf dem weiteren Trägerelement bereitgestellten Leiterschleifenanordnung 124 ein elektrischer Strom induziert wird.

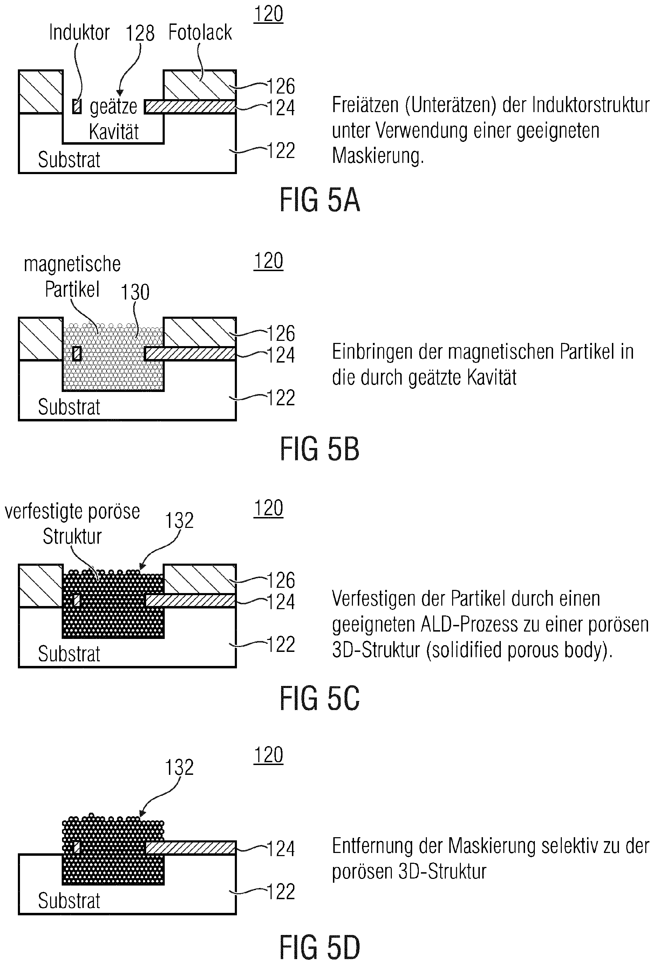

Im Folgenden wird bezugnehmend auf Fig. 5a bis 5d ein Verfahren 100 zum Herstellen einer Vorrichtung 120 mit einer dreidimensionalen magnetischen Struktur beschrieben, bei der die Leiterschleifenanordnung 124 auf dem gleichen Trägerelement 122 wie die dreidimensionale magnetische Struktur bereitgestellt wird, so dass eine Induktivität der Leiterschleifenanordnung 124 durch die dreidimensionale magnetische Struktur verändert wird.

Fig. 5a zeigt eine schematische Querschnittsansicht der Vorrichtung 120 nach einem Schritt des Bereitstellens einer Maskierung 126 auf dem Trägerelement 122 und der Leiterschleifenanordnung 124 und eines Schritts des Ätzens des Trägerelements 122 in einem durch die Maskierung 126 definierten Bereich, um eine Kavität 128 in dem Trägerelement 122 im Bereich der Leiterschleifenanordnung 124 zu erhalten. Somit kann die Leiterschleifenanordnung (Induktorstruktur) 124, wie in Fig. 5a gezeigt ist, unter Verwendung einer geeigneten Maskierung freigeätzt (oder unterätzt) werden.

Fig. 5b zeigt eine schematische Querschnittsansicht der Vorrichtung 120 nach dem Schritt 102 des Auf- oder Einbringens der magnetischen Partikel 130 auf oder in das Trägerelement 122. Das Auf- oder Einbringen der magnetischen Partikel 130 kann dabei derart erfolgen, dass die Leiterschleifenanordnung 124 die magnetischen Partikel 130 zumindest teilweise umfasst (bzw. umschließt), d.h. dass die magnetischen Partikel 130 zumindest teilweise innerhalb der Leiterschleifenanordnung 124 angeordnet sind. Ferner kann das Auf- oder Einbringen der magnetischen Partikel 130 derart erfolgen, dass die magnetischen Partikel die Leiterschleifenanordnung 124 zumindest teilweise umfassen (bzw. umschließen), d.h. dass die magnetischen Partikel 130 zumindest teilweise außerhalb der Leiterschleifenanordnung 124 angeordnet sind, z.B. um die Leiterschleifenanordnung 124 herum angeordnet sind. In Fig. 5b sind die magnetischen Partikel 130 sowohl innerhalb als auch außerhalb der Leiterschleifenanordnung 124 angeordnet. Fig. 5b zeigt somit die Vorrichtung 120 nach den Einbringen der magnetischen Partikel 130 in die geätzte Kavität 128.

Fig. 5c zeigt eine schematische Querschnittsansicht der Vorrichtung 120 nach dem Schritt 104 des Verbindens der magnetischen Partikel 130 an den Berührungspunkten durch Beschichten der Anordnung aus magnetischen Partikeln 130 und Trägerelement 122, wobei die Hohlräume zumindest teilweise von der beim Beschichten erzeugten Schicht durchdrungen werden, so dass die dreidimensionale magnetische Struktur 132 entsteht. Mit anderen Worten, Fig. 5c zeigt eine schematische Querschnittsansicht der Vorrichtung 120 nach dem Verfestigen der Partikel 130 durch einen geeigneten ALD-Prozess zu einer porösen dreidimensionalen Struktur (engl.: solidified porous body).

Fig. 5d zeigt eine schematische Querschnittsansicht der Vorrichtung 120 nach einem Schritt des Entfernens der Maskierung 126 selektiv zu der porösen dreidimensionalen Struktur 132. Durch die dreidimensionale magnetische Struktur 132 wird die Induktivität der Leiterschleifenanordnung 124 verändert.

Mit anderen Worten, in Fig. 5a bis 5d ist schematisch dargestellt, wie die Leiterschleifenanordnung (Induktorstruktur) 124 mit einer magnetischen Ummantelung versehen werden kann. Zuerst kann die Leiterschleifenanordnung (Induktorstruktur) 124 mittels einer geeigneten Maskierung, z.B. eines Fotolacks, frei- bzw. untergeätzt werden (Fig. 5a). Dazu stehen in der IC-Technologie (IC = Integrated Circuit, dt.: integrierter Schaltkreis) verschiedene Trockenätzprozesse zur Verfügung. Anschließend können die Partikel 130 aufgebracht werden (Fig. 5b). Das kann sowohl trocken als auch aus einer geeigneten Suspension mit niedriger Viskosität und guter Benetzung erfolgen, so dass die Partikel 130 leicht unter die Leiterschleifenanordnung (Induktor) 124 gelangen können. Für polymergebundene Partikel, wie in [S. Engelkraut et. al., "Polymer bonded soft magnetic particles for planar inductive devices", Proc. CIPS 2008, Nürnberg, Germany], [P. Markondeya et. al., "Novel nanomagnetic materials for high-frequency RF applications", Proc. ECTC 2011] und [S. Lyshevski, K. Martirosyan, "Ferrite nanoparticles for MEMS technology sensors and actuators", Proc. IEEE Conf. on Nanotechnology, Portland, Oregon, USA, 2011] verwendet, ist das nicht möglich, da das Ausgangsmaterial sehr niedrigviskos ist und gut haften muss. Nach dem Trocknen (falls notwendig) werden die noch losen Partikel 130 durch einen ALD-Prozess, z. B. Al₂O₃, miteinander verbunden (Fig. 5c). Wird Al₂O₃ verwenden, hat dies den Vorteil, dass es schon bei Raumtemperatur abgeschieden werden kann, und somit kompatibel zu herkömmlichem Fotolack ist. Je kleiner die Partikel 130 sind, umso dünner kann die ALD-Schicht sein. 10 bis 50 nm sind bei Partikelgrößen bis 1 µm ausreichend. Danach kann der Fotolack 126 entfernt werden (Fig. 5d). Anschließend kann eine herkömmliche PECVD-Schicht (PECVD = Plasma-Enhanced Chemical Vapour Deposition, dt.: Plasmaunterstützte chemische Gasphasenabscheidung) zur Passivierung der Struktur abgeschieden werden. Sollen die Partikel 130 durch eine magnetische Schicht, wie z.B. Fe₂O₃ oder NiO, verbunden werden, die eine Abscheidetemperatur von 200°C erfordert, kann eine andere Maskierung anstelle des Fotolacks verwendet werden. Der Fotolack kann auch vor dem Einbringen der Partikel 130 entfernt werden, wenn letzteres z. B. durch Dispensen (wie Tintenstrahldrucken) erfolgen kann. Die poröse magnetische Struktur 132 kann auch nur oberhalb der Leiterschleifenanordnung (Induktor) 124 ohne vorheriges Freiätzen erzeugt werden.

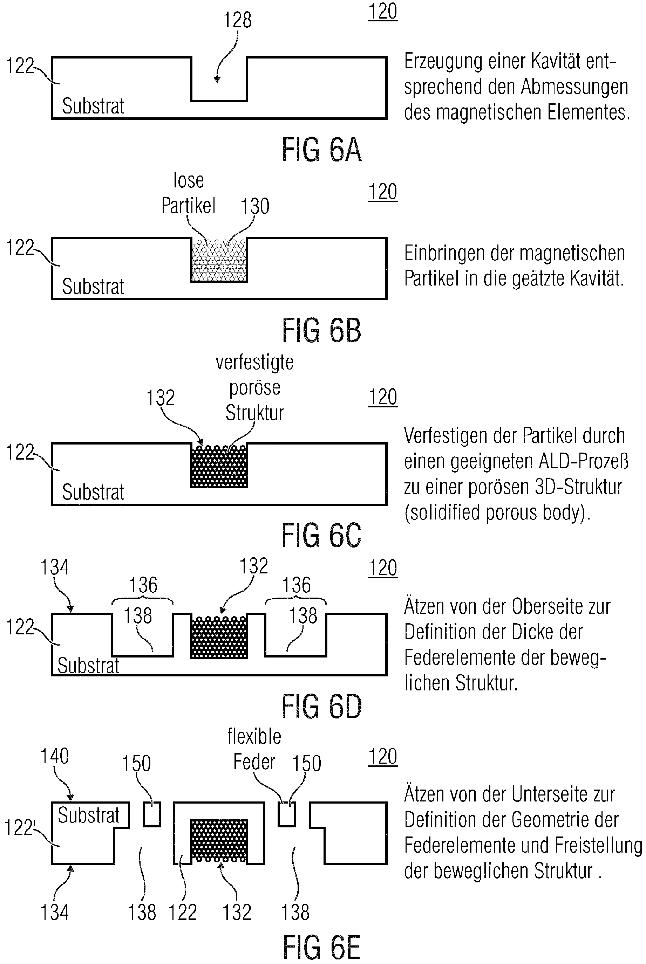

Im Folgenden wird bezugnehmend auf Fig. 6a bis 6e ein Verfahren 100 zum Herstellen einer Vorrichtung 120 mit einer dreidimensionalen magnetischen Struktur 132 beschrieben, bei dem die Leiterschleifenanordnung 124 derart bereitgestellt wird, dass bei einem Stromfluss durch die Leiterschleifenanordnung 124 eine Kraft auf die dreidimensionale magnetische Struktur 132 oder die Leiterschleifenanordnung 124 durch ein durch den Stromfluss hervorgerufenes magnetisches Feld wirkt.

Mit anderen Worten, im Folgenden wird anhand von Fig. 6a bis 6e gezeigt, dass auf ähnliche Weise magnetische Strukturen auch auf beweglichen Elementen, wie z.B. einer Spiegelplatte eines Scanners oder dem Aktuator eines Lautsprechers, erzeugt werden können, um das Aufkleben von Hartmagneten (etwa aus SmCo oder NdFeB) auf Chipebene zu ersetzen. Zum einen können auf diese Weise wesentlich feinere Strukturen erzeugt werden. Zum anderen kann die Reproduzierbarkeit der Strukturen höher sein. Zudem kann durch die Herstellung auf Waferebene das Verfahren kostengünstiger sein.

Fig. 6a zeigt eine schematische Querschnittsansicht der Vorrichtung 120 nach einem Schritt des Bereitstellen eines Trägerelements 122 mit einer Kavität 128. Die Kavität 128 kann dabei entsprechend den Abmessungen der dreidimensionalen magnetischen Struktur 132 erzeugt werden.

Fig. 6b zeigt eine schematische Querschnittsansicht der Vorrichtung 120 nach dem Schritt 102 des Einbringens von magnetischen Partikeln 130 in die (geätzte) Kavität 128 des Trägerelements 122, wobei zwischen den magnetischen Partikeln 130 eine Vielzahl von zumindest teilweise miteinander verbundener Hohlräume gebildet wird, und wobei die magnetischen Partikel 130 an Berührungspunkten miteinander in Kontakt treten.

Fig. 6c zeigt eine schematische Querschnittsansicht der Vorrichtung 120 nach dem Schritt 104 des Verbindens der magnetischen Partikel 130 an den Berührungspunkten durch Beschichten der Anordnung aus magnetischen Partikeln 130 und Trägerelement 122, wobei die Hohlräume zumindest teilweise von der beim Beschichten erzeugten Schicht durchdrungen werden, so dass die dreidimensionale magnetische Struktur 132 entsteht. Die Partikel 130 werden somit durch einen geeigneten ALD-Prozess zu einer porösen dreidimensionalen Struktur (engl. solidified porous body) 132 verfestigt.

Fig. 6d zeigt eine schematische Querschnittsansicht der Vorrichtung 120 nach einem Schritt des Ätzens des Trägerelements 122 ausgehend von einer Oberseite 134 des Trägerelements 122 in einem Bereich 136 um die dreidimensionale magnetische Struktur 132 herum, um eine Kavität 138 zu erhalten, die die Dicke von Federelementen einer beweglichen Struktur definiert.

Fig. 6e zeigt eine schematische Querschnittsansicht der Vorrichtung 102 nach einem Schritt des Ätzens des Trägerelements 122 ausgehend von einer Unterseite 140 des Trägerelements 122 zur Definition der Geometrie der Federelemente und Freistellung der beweglichen Struktur.

Wie in Fig. 6e zu erkennen ist, wird das Trägerelement 122 durch den letzten Ätzvorgang in zwei Trägerelemente 122 und 122' aufgeteilt, d.h. in ein Trägerelement 122 und ein weiteres Trägerelement 122'. Natürlich kann bei Ausführungsbeispielen auch ein Trägerelement 122 und ein weiteres Trägerelement 122' (unabhängig voneinander) bereitgestellt werden.

Die Leiterschleifenanordnung 124 (nicht gezeigt) kann dabei beispielsweise auf dem weiteren Trägerelement 122' bereitgestellt werden, wobei das Trägerelement 122 und das weitere Trägerelement 122' über die Federelemente 150 miteinander gekoppelt sind, so dass durch die Kraft, die auf die dreidimensionale magnetische Struktur 132 durch ein durch den Stromfluss hervorgerufenes magnetisches Feld wirkt, eine relative Auslenkung zwischen dem Trägerelement 122 und dem weiteren Trägerelement 122' hervorgerufen wird.

Dabei kann das Trägerelement 122 beweglich und das weitere Trägerelement 122' starr angeordnet sein. Natürlich kann auch das weitere Trägerelement 122' beweglich und das Trägerelement 122 starr angeordnet sein.

Mit anderen Worten, ein möglicher Herstellungsprozess ist schematisch in Fig. 6a bis 6e dargestellt. Es kann eine Kavität 128 erzeugt werden, in der sich der magnetische Körper befinden soll (Fig. 6a). Die Kavität 128 kann mit magnetischen Partikeln 130 befüllt werden (Fig. 6b), mit oder ohne Maskierung der Substratoberfläche 134. Anschließend können die Partikel 130 durch ALD verfestigt werden (Fig. 6c). Danach kann die bewegliche Struktur definiert werden. In diesem Fall kann zuerst von der Vorderseite 134 geätzt, um die Dicke der Federelemente zu bestimmen (Fig. 6d). Durch das anschließende Ätzen von der Unterseite 140 kann die Geometrie der Federelemente definiert und die bewegliche Struktur freigestellt werden (Fig. 6e).

Ausführungsbeispiele der vorliegenden Erfindung beziehen sich auf die Erzeugung eines magnetischen Kernes auf einer Spule oder einer metallischen Leiterbahn bzw. um eine Spule oder eine metallische Leiterbahn herum durch Auf- bzw. Einbringen magnetischer Partikel in eine vorgegebene Form auf der Spule oder metallischen Leiterbahn bzw. in eine die Spule oder metallische Leiterbahn vollständig oder teilweise umschließende Kavität und Verbinden der Partikel zu einem porösen dreidimensionalen Körper mittels ALD.

Ausführungsbeispiele beziehen sich auf die Erzeugung magnetischer dreidimensionaler Körper unterschiedlicher Geometrie mit Abmessungen von mehreren µm bis zu mehreren mm für den magnetischen Antrieb mikromechanischer Bauelemente, z. B. Spiegel, Lautsprecher, Schalter oder Relais, durch Einbringen von Partikeln in eine Form auf einem Substrat, auf dem sich das mikromechanische Bauelement vollständig oder nur teilweise befindet, und deren anschließendes Verfestigen mittels ALD.

Ausführungsbeispiele eignen sich zum Herstellen von Induktoren oder mikromechanischen Aktuatoren auf einem planaren Substrat. Als Substratmaterial kann Silizium, Galliumarsenid, Glas, Keramik, Leiterplatten, Kunststoffe und Metalle verwendet werden.

Bei Ausführungsbeispielen können die verwendeten Partikel eine Größe von bevorzugt mehreren 10 nm bis zu 10 µm haben und können aus beliebigen weich- oder ferromagnetischen als auch hartmagnetischen Materialien bestehen, die kompatibel zu den nachfolgenden Prozessen sind, insbesondere der ALD-Abscheidung zum Verbinden der Partikel.

Bei Ausführungsbeispielen können zum Verbinden der Partikel neben normalen Dielektrika, wie z. B. Al₂O₃ und TiO₂ auch magnetische Schichten, wie z.B. Eisen-, Nickel- oder Kobaltoxid, mittels ALD abgeschieden werden. Diese Oxide könne auch durch eine nachfolgende chemische Reduktion in Metalle überführt werden, wodurch insbesondre für die Herstellung hartmagnetischer Komponenten größere Magnetfeldstärken erreicht werden können.

Bei Ausführungsbeispielen kann, wenn die Spule Teil eines aktiven integrierten Schaltkreises auf einem Halbleitersubstrat ist, der poröse magnetische Kern nach deren vollständiger Fertigstellung erzeugt werden.

Bei Ausführungsbeispielen kann der magnetische dreidimensionale Körper auch zu Anfang des Prozesses hergestellt und durch geeignete Passivierungsschichten vor den nachfolgenden Prozessen geschützt werden, wenn der magnetische dreidimensionale Körper für einen Aktuator benötigt, z. B. unter Verwendung eines hartmagnetischen Pulvers, wird.

Bei Ausführungsbeispielen kann ein Substrat mit den magnetischen dreidimensionalen Körpern oder auch ein einzelner Chip durch geeignete Prozesse mit weiteren Substraten oder Chips zum mikromechanischen Bauelement verbunden werden.

Bei Ausführungsbeispielen können besonders leistungsfähige magnetische Materialien verwendet werden, die sich nicht durch andere Verfahren auf ein Substrat IC-kompatibel bzw. in den benötigten Abmessungen integrieren lassen.

Bei Ausführungsbeispielen lassen sich magnetische Strukturen sehr unterschiedlicher Größe auf einer Vielzahl verschiedener Substrate herstellen.

Bei Ausführungsbeispielen können zum Verbinden der Partikel z.B. magnetische Materialien mittels ALD abgeschieden werden, wodurch die Eigenschaften des magnetischen Körpers noch verbessert werden können.

Ausführungsbeispiele ermöglichen es, besonders leistungsfähige magnetische Materialien zu verwenden, die sich nicht durch andere Verfahren auf ein Substrat IC-kompatibel bzw. in den benötigten Abmessungen integrieren lassen.

Bei Ausführungsbeispielen lassen sich magnetische Strukturen sehr unterschiedlicher Größe auf einer Vielzahl verschiedener Substrate herstellen.

Bei Ausführungsbeispielen können die Eigenschaften des magnetischen Körpers verbessert werden, wenn zum Verbinden der Partikel, z.B. magnetische Materialien mittels ALD abgeschieden werden.

## Patentansprüche

1. Verfahren (100) zum Herstellen einer Vorrichtung (120) mit einer dreidimensionalen magnetischen Struktur (132), wobei das Verfahren folgende Schritte aufweist:
Auf- oder Einbringen (102) von magnetischen Partikeln (130) auf oder in ein Trägerelement (122), wobei zwischen den magnetischen Partikeln (130) eine Vielzahl von zumindest teilweise miteinander verbundener Hohlräume gebildet wird und wobei die magnetischen Partikel (130) an Berührungspunkten miteinander in Kontakt treten;
Verbinden (104) der magnetischen Partikel (130) an den Berührungspunkten durch Beschichten der Anordnung aus magnetischen Partikeln (130) und Trägerelement (122), wobei die Hohlräume zumindest teilweise von der beim Beschichten erzeugten Schicht durchdrungen werden, so dass die dreidimensionale magnetische Struktur (132) entsteht, wobei das Beschichten der Anordnung aus magnetischen Partikeln (130) und Trägerelement (122) mittels einer Atomlagenabscheidung durchgeführt wird; und
Bereitstellen (106) einer Leiterschleifenanordnung (124) auf dem Trägerelement (122) oder einem weiteren Trägerelement (122'), so dass
- bei einem Stromfluss durch die Leiterschleifenanordnung (124) eine Induktivität der Leiterschleifenanordnung (124) durch die dreidimensionale magnetische Struktur (132) verändert wird; oder
- bei einem Stromfluss durch die Leiterschleifenanordnung (124) eine Kraft auf die dreidimensionale magnetische Struktur (132) oder die Leiterschleifenanordnung (124) durch ein durch den Stromfluss hervorgerufenes magnetisches Feld wirkt; oder
- bei einer einmaligen oder periodischen Lageänderung der dreidimensionalen magnetischen Struktur (132) ein Stromfluß durch die Leiterschleifenanordnung (124) induziert wird.

2. Verfahren (100) nach Anspruch 1, wobei das Auf- oder Einbringen (102) der magnetischen Partikel (130) auf oder in das Trägerelement (122) derart erfolgt, dass die Leiterschleifenanordnung (124) die magnetischen Partikel (130) zumindest teilweise umfasst oder die magnetischen Partikel (130) die Leiterschleifenanordnung (124) zumindest teilweise umfassen.

3. Verfahren (100) nach Anspruch 2, wobei das Trägerelement (122) eine Kavität (128) im Bereich der Leiterschleifenanordnung (124) aufweist, und wobei die magnetischen Partikel (130) in die Kavität (128) derart eingebracht werden, dass die Leiterschleifenanordnung (124) die magnetischen Partikel (130) zumindest teilweise umfasst oder die magnetischen Partikel (130) die Leiterschleifenanordnung (124) zumindest teilweise umfassen.

4. Verfahren (100) nach einem der Ansprüche 1 bis 3, wobei bei dem Bereitstellen (106) der Leiterschleifenanordnung (124) eine Mehrzahl von voneinander isolierter Leiterschleifenanordnungen bereitgestellt werden, wobei das Auf- oder Einbringen (102) der magnetischen Partikel (130) derart erfolgt, dass die Mehrzahl von Leiterschleifenanordnungen mittels der magnetischen Partikel (130) miteinander induktiv gekoppelt sind.

5. Verfahren (100) nach einem der Ansprüche 1 bis 4, wobei die Leiterschleifenanordnung (124) auf dem weiteren Trägerelement (122') bereitgestellt wird, wobei das Trägerelement (122) und das weitere Trägerelement (122') über Federelemente (150) miteinander gekoppelt sind, so dass durch die Kraft, die auf die dreidimensionale magnetische Struktur (132) durch ein durch den Stromfluss hervorgerufenes magnetisches Feld wirkt, eine relative Auslenkung zwischen dem Trägerelement (122) und dem weiteren Trägerelement (122') hervorgerufen wird.

6. Verfahren (100) nach Anspruch 5, wobei das Trägerelement (122) beweglich und das weitere Trägerelement (122') starr angeordnet ist.

7. Verfahren (100) nach Anspruch 5, wobei das weitere Trägerelement (122') beweglich und das Trägerelement (122) starr angeordnet ist.

8. Verfahren (100) nach einem der Ansprüche 1 bis 7, wobei das Beschichten der Anordnung aus magnetischen Partikeln (130) und Trägerelement (122) folgenden Schritt aufweist:
Abscheiden einer magnetischen Schicht.

9. Verfahren (100) nach Anspruch 8, wobei das Beschichten der Anordnung aus magnetischen Partikeln (130) und Trägerelement (122) folgenden Schritt aufweist:
Abscheiden eines magnetischen Materials in oxidierter Form, um die magnetische Schicht zu erhalten.

10. Verfahren (100) nach einem der Ansprüche 1 bis 9, wobei die magnetischen Partikel (130) weich- und/oder hartmagnetische Werkstoffe aufweisen.

11. Verfahren (100) nach einem der Ansprüche 1 bis 10, wobei die Anordnung aus magnetischen Partikeln (130) nach der Beschichtung in einer Vorzugsrichtung aufmagnetisiert wird.

12. Verfahren (100) nach einem der Ansprüche 1 bis 11, wobei das Trägerelement (122) und/oder das weitere Trägerelement (122') Kunststoff, Silizium, Glas oder Keramik aufweisen.

13. Verfahren (100) nach einem der Ansprüche 1 bis 12, wobei das Trägerelement (122) und/oder das weitere Trägerelement (122') eine Leiterplatte ist.

14. Verfahren (100) nach einem der Ansprüche 1 bis 13, wobei das Auf- oder Einbringen (102) von magnetischen Partikeln (130) und/oder das Verbinden (104) der magnetischen Partikel (130) derart erfolgt, dass die dreidimensionale magnetische Struktur (132) eine kreisförmige Form mit abwechselnden weich- und hartmagnetischen Abschnitten aufweist.

15. Vorrichtung (120) mit einer dreidimensionalen magnetischen Struktur, hergestellt mit dem Verfahren nach einem der Ansprüche 1 bis 14.

## Claims

1. A method (100) for manufacturing a device (120) having a three-dimensional magnetic structure (132), the method comprising the steps of:
applying or introducing (102) magnetic particles (130) onto or into a carrier element (122), wherein a plurality of at least partly interconnected cavities are formed between the magnetic particles (130), and wherein the magnetic particles (130) contact one another at points of contact;
connecting (104) the magnetic particles (130) at the points of contact by coating the arrangement of magnetic particles (130) and the carrier element (122), wherein the cavities are penetrated at least partly by the layer generated when coating so that the result is the three-dimensional magnetic structure (132), said coating of the arrangement of magnetic particles (130) and carrier element (122) being performed by means of atomic layer deposition; and
providing (106) a conductor loop arrangement (124) on the carrier element (122) or a further carrier element (122') so that:
- when a current flows through the conductor loop arrangement (124), an inductance of the conductor loop arrangement (124) is changed by the three-dimensional magnetic structure (132); or
- when a current flows through the conductor loop arrangement (124), a force acts on the three-dimensional magnetic structure (132) or the conductor loop arrangement (124) by a magnetic field caused by the current flow; or
- when a position of the three-dimensional magnetic structure (132) is changed once or periodically, a current flow is induced through the conductor loop arrangement (124).

2. The method (100) in accordance with claim 1, wherein applying or introducing (102) the magnetic particles (130) onto or into the carrier element (122) takes place such that the conductor loop arrangement (124) encloses the magnetic partides (130) at least partly, or that the magnetic particles (130) enclose the conductor loop arrangement (124) at least partly.

3. The method (100) in accordance with claim 2, wherein the carrier element (122) comprises a cavity (128) in the region of the conductor loop arrangement (124), and wherein the magnetic particles (130) are introduced into the cavity (128) such that the conductor loop arrangement (124) encloses the magnetic particles (130) at least partly, or that the magnetic particles (130) enclose the conductor loop arrangement (124) at least partly.

4. The method (100) in accordance with any of claims 1 to 3, wherein, when providing (106) the conductor loop arrangement (124), a plurality of mutually insulated conductor loop arrangements are provided, wherein applying or introducing (102) the magnetic particles (130) takes place such that the plurality of conductor loop arrangements are inductively coupled to one another by means of the magnetic particles (130).

5. The method (100) in accordance with any of claims 1 to 4, wherein the conductor loop arrangement (124) is provided on the further carrier element (122'), wherein the carrier element (122) and the further carrier element (122') are coupled to each other by means of spring elements (150) so that a relative deflection between the carrier element (122) and the further carrier element (122') is caused by the force acting on the three-dimensional magnetic structure (132) by a magnetic field caused by the current flow.

6. The method (100) in accordance with claim 5, wherein the carrier element (122) is arranged to be movable and the further carrier element (122') is arranged to be fixed.

7. The method (100) in accordance with claim 5, wherein the further carrier element (122') is arranged to be movable and the carrier element (122) is arranged to be fixed.

8. The method (100) in accordance with any of claims 1 to 7, wherein coating of the arrangement of magnetic particles (130) and the carrier element (122) further comprises the step of:
depositing a magnetic layer.

9. The method (100) in accordance with claim 8, wherein coating of the arrangement of magnetic particles (130) and the carrier element (122) further comprises the step of:
depositing a magnetic material in an oxidized form in order to obtain the magnetic layer.

10. The method (100) in accordance with any of claims 1 to 9, wherein the magnetic particles (130) comprise soft and/or hard magnetic materials.

11. The method (100) in accordance with any of claims 1 to 10, wherein the arrangement of magnetic particles (130) is magnetized to a preferential direction after coating.

12. The method (100) in accordance with any of claims 1 to 11, wherein the carrier element (122) and/or the further carrier element (122') comprise(s) plastic, silicon, glass or ceramic.

13. The method (100) in accordance with any of claims 1 to 12, wherein the carrier element (122) and/or the further carrier element (122') are (is) a conductor board.

14. The method (100) in accordance with any of claims 1 to 13, wherein said applying or introducing (102) of magnetic particles (130) and/or said connecting (104) of the magnetic particles (130) take(s) place such that the three-dimensional magnetic structure (132) comprises a circular shape having alternating soft and hard magnetic portions.

15. A device (120) comprising a three-dimensional magnetic structure which is manufactured by the method in accordance with any of claims 1 to 14.

## Revendications

1. Procédé (100) de fabrication d'un dispositif (120) avec une structure magnétique tridimensionnelle (132), le procédé présentant les étapes suivantes consistant à:
déposer ou introduire (102) des particules magnétiques (130) sur ou dans un élément de support (122), où une pluralité de cavités connectées au moins partiellement entre elles sont formées entre les particules magnétiques (130), et où les particules magnétiques (130) entrent en contact entre elles à des points de contact;
connecter (104) les particules magnétiques (130) aux points de contact en revêtant l'aménagement composé des particules magnétiques (130) et de l'élément de support (122), où les cavités sont pénétrées au moins partiellement par la couche générée lors du revêtement, de sorte que soit créée la structure magnétique tridimensionnelle (132), où le revêtement de l'aménagement composé des particules magnétiques (130) et de l'élément de support (122) est réalisé par un dépôt de couche d'atomes; et
prévoir (106) un aménagement de boucle de conducteur (124) sur l'élément de support (122) ou un autre élément de support (122'), de sorte que
- en cas d'un flux de courant à travers l'aménagement de boucle de conducteur (124) soit modifiée une inductance de l'aménagement de boucle de conducteur (124) par la structure magnétique tridimensionnelle (132); ou
- en cas d'un flux de courant à travers l'aménagement de boucle de conducteur (124) agisse une force sur la structure magnétique tridimensionnelle (132) ou l'aménagement de boucle de conducteur (124) par un champ magnétique créé par le flux de courant; ou
- en cas changement de position unique ou périodique de la structure magnétique tridimensionnelle (132) soit induit un flux de courant à travers l'aménagement de boucle de conducteur (124).

2. Procédé (100) selon la revendication 1, dans lequel le dépôt ou l'introduction (102) des particules magnétiques (130) sur ou dans l'élément de support (122) a lieu de sorte que l'aménagement de boucle de conducteur (124) entoure au moins partiellement les particules magnétiques (130) ou les particules magnétiques (130) entourent au moins partiellement l'aménagement de boucle de conducteur (124).

3. Procédé (100) selon la revendication 2, dans lequel l'élément de support (122) présente une cavité (128) à l'endroit de l'aménagement de boucle de conducteur(124), et dans lequel les particules magnétiques (130) sont introduites dans la cavité (128) de sorte que l'aménagement de boucle de conducteur (124) entoure au moins partiellement les particules magnétiques (130) ou les particules magnétiques (130) entourent au moins partiellement l'aménagement de boucle de conducteur (124).

4. Procédé (100) selon l'une des revendications 1 à 3, dans lequel lors de la prévision (106) de l'aménagement de boucle de conducteur (124) sont prévues une pluralité d'aménagements de boucle de conducteur isolés l'un de l'autre, dans lequel le dépôt ou l'introduction (102) des particules magnétiques (130) a lieu de sorte que la pluralité d'aménagements de boucle de conducteur soient couplés de manière inductive l'un à l'autre par les particules magnétiques (130).

5. Procédé selon la revendication 1, dans lequel l'aménagement de boucle de conducteur (124) est prévu sur l'autre élément de support (122'), dans lequel l'élément de support (122) et l'autre élément de support (122') sont couplés l'un à l'autre par des éléments de ressort (150), de sorte que par la force qui agit sur la structure magnétique tridimensionnelle (132) par un champ magnétique créé par le flux de courant soit provoquée une déviation relative entre l'élément de support (122) et l'autre élément de support (122').

6. Procédé (100) selon la revendication 5, dans lequel l'élément de support (122) est disposé de manière déplaçable et l'autre élément de support (122') est disposé de manière rigide.

7. Procédé (100) selon la revendication 5, dans lequel l'autre élément de support (122') est disposé de manière déplaçable et l'élément de support (122) est disposé de manière rigide.

8. Procédé (100) selon l'une des revendications 1 à 7, dans lequel le revêtement de l'aménagement composé des particules magnétiques (130) et de l'élément de support (122) présente l'étape suivante consistant à:
déposer une couche magnétique.

9. Procédé (100) selon la revendication 8, dans lequel le revêtement de l'aménagement composé des particules magnétiques (130) et de l'élément de support (122) présente l'étape suivante consistant à:
déposer un matériau magnétique sous forme oxydée pour obtenir la couche magnétique.

10. Procédé (100) selon l'une des revendications 1 à 9, dans lequel les particules magnétiques (130) présentent des matériaux magnétiques souples et/ou durs.

11. Procédé (100) selon l'une des revendications 1 à 10, dans lequel l'aménagement composé des particules magnétiques (130) est magnétisé, après le revêtement, dans une direction préférée.

12. Procédé (100) selon l'une des revendications 1 à 11, dans lequel l'élément de support (122) et/ou l'autre élément de support (122') présentent de la matière plastique, du silicium, du verre ou de la céramique.

13. Procédé (100) selon l'une des revendications 1 à 12, dans lequel l'élément de support (122) et/ou l'autre élément de support (122') sont une carte de circuit imprimé.

14. Procédé (100) selon l'une des revendications 1 à 13, dans lequel le dépôt ou l'introduction (102) de particules magnétiques (130) et/ou la connexion (104) des particules magnétiques (130) a lieu de sorte que la structure magnétique tridimensionnelle (132) présente une forme circulaire avec des segments magnétiques souples et dures alternés.

15. Dispositif (120) avec une structure magnétique tridimensionnelle, réalisé par le procédé selon l'une des revendications 1 à 14.
